(19) Europäisches Patentamt

European Patent Office

Office européen des brevets

(11) **EP 0 810 653 B1**

(12) **EUROPEAN PATENT SPECIFICATION**

(45) Date of publication and mention
of the grant of the patent:
**28.07.2004 Bulletin 2004/31**

(51) Int Cl.⁷: **H01L 21/8242**, H01L 27/108

(21) Application number: **97108727.5**

(22) Date of filing: **30.05.1997**

(54) **DRAM and method of fabricating a DRAM with increased capacity**

DRAM und Verfahren zur Herstellung von DRAM mit erhöhter Kapazität

DRAM et procédé pour la fabrication de DRAM ayant une capacité accrue

(84) Designated Contracting States:
**DE FR GB IT NL**

(30) Priority: **31.05.1996 US 18764 P**

(43) Date of publication of application:
**03.12.1997 Bulletin 1997/49**

(73) Proprietor: **TEXAS INSTRUMENTS
INCORPORATED**
**Dallas Texas 75265 (US)**

(72) Inventor: **Wise, Rick L.**
**Plano, Texas 75025 (US)**

(74) Representative:
**Degwert, Hartmut, Dipl.-Phys. et al**
**Prinz & Partner GbR,**
**Manzingerweg 7**
**81241 München (DE)**

(56) References cited:
**EP-A- 0 427 200          EP-A- 0 448 374**
**DE-A- 4 229 363          US-A- 5 080 933**

• **PATENT ABSTRACTS OF JAPAN vol. 018, no.
255 (E-1548), 16 May 1994 & JP 06 037256 A (FUJI
ELECTRIC CO LTD), 10 February 1994,**
• **DATABASE WPI Section Ch, Week 9240 Derwent
Publications Ltd., London, GB; Class L03, AN
92-048270 XP002038955 & JP 04 234 112 A
(MOTOROLA INC) , 21 August 1992**

## Description

### TECHNICAL FIELD OF THE INVENTION

This invention relates generally to integrated circuit, and more particularly to a method of fabricating a dynamic random access memory with increased capacitance.

### BACKGROUND OF THE INVENTION

Dynamic random access memory ("DRAM") cells typically consist of one transistor and one capacitor. One of the goals in the design of DRAMs is to increase the memory capacity of each integrated circuit. To increase the memory capacity, significant efforts have been made at decreasing the size of each of the memory cells that make up the DRAM. One of the most challenging problems faced by DRAM designers is the maintenance of sufficient charge-storage capacity in the capacitors of the memory cells as their size is decreased.

Important parameters involved in increasing the charge stored on the capacitor are typically the dielectric constant, thickness of the insulator, and surface area of the capacitor. Many techniques have been investigated for increasing the charge-storage capacity in capacitors without increasing the area (footprint) the DRAM cells occupy on a chip's surface or the size (volume) of the DRAM cell. One example is a trench capacitor in which the capacitor is formed as part of a trench formed in a substrate with the transistor disposed on the surface of the substrate. A trench capacitor may include a plate electrode of the capacitor inside the trench and a storage electrode on the substrate.

Another approach that allows a memory cell to shrink in size without a loss of its storage capacity is stacking the storage capacitor on top of the associated transistor. DRAM cells made through this process are sometimes called stacked capacitor DRAMs. Although stack capacitor DRAMs may reduce the planar surface area required by a capacitor, they are generally formed significantly above the surface of the substrate in which the DRAM cell is formed, which leads to topological problems in the formation of subsequent layers of the associated integrated circuit.

A method of forming a fin-type stacked capacitor is known from Patent Abstracts of Japan, volume 018, No. 255 (E-1548), 16 May 1994 and JP-A-06 037256. A substrate is covered with a protective film and PSG films and LTO films are alternately provided thereon. A through-hole is formed by etching primarily the PSG films, and polysilicon is filled into produced empty spaces and patterned for the formation of fins. The PSG films and the LTO films are removed at a time by etching, and the exposed surface of the polysilicon is thermally oxidized to form a dielectric film. Cell plates serving as opposed electrodes and a joint are formed thereafter.

Another method of forming a fin-type stacked capacitor is known from DE-A-42 29 363. The method comprises alternately depositing layers of dielectric materials which are selectively wet-etchable with respect to each other, isotropically etching the layers to form a void with fin-type side walls, depositing a layer of doped polysilicon, depositing a dielectric layer and depositing a layer of in situ doped polysilicon over the dielectric layer.

In this context, reference is further made to EP-A-0 448 374, which discloses a method for fabricating polysilicon having micro roughness on the surface. The method comprises depositing a polysilicon layer in such a manner that grains of silicon are formed at the surface of the polysilicon layer. The polysilicon layer thus obtained has a large effective surface area and is suitable for a capacitor electrode.

### SUMMARY OF THE INVENTION

According to the teachings of the present invention a method for forming a storage capacitor for a dynamic random access memory cell having a storage capacitor is provided. That method includes: depositing a first film having a first etch selectivity and depositing on the first film a second film having a different second etch selectivity. The steps of depositing the first and second films are repeated at least one time to form a plurality of first film layers alternated with a plurality of second film layers. A void is then etched through the pluralities of first and second film layers through selective etching of the plurality of first and second film layers, a plurality of undercut areas is formed.

Silicon is then selectively deposited only in the void. By overgrowing the selectively deposited silicon, at least a portion of the undercut areas is filled with silicon. After removing the pluralities of first and second film layers a capacitor dielectric is formed over the selectively deposited silicon. A conductive material is then deposited over the dielectric.

### BRIEF DESCRIPTION OF THE DRAWINGS

For a more complete understanding of the present invention, and the advantages thereof, reference is now made to the following descriptions taken in conjunction with the accompanying drawings, in which:

FIGURE 1 is a schematic drawing in section with portions broken away of a DRAM cell fabricated according to the teachings of the present invention on a semiconductor substrate;

FIGURE 2 is a schematic drawing in section with portions broken away of a DRAM storage capacitor, during formation of a first oxide layer and a first nitride layer;

FIGURE 3 is a schematic drawing in section with portions broken away of a DRAM storage capacitor, during formation of a plurality of alternating layers of doped and undoped material;

FIGURE 4 is a schematic drawing in section with portions broken away showing a DRAM storage capacitor showing formation of a storage capacitor, after etching a void in the oxide and nitride layers and the alternating layers of doped and undoped material;

FIGURE 5 is a schematic drawing in section with portions broken away of a portion of a DRAM memory cell during processing showing the fabrication of the lower storage node after further etching of the alternating layers;

FIGURE 6 is a schematic drawing in section with portions broken away of the corrugated post storage capacitor during fabrication after selective deposition of silicon;

FIGURE 7A is a schematic drawing in section with portions broken away of a corrugated post storage capacitor during fabrication, after removal of the alternating layers of doped and undoped material;

FIGURE 7B is a schematic drawing in section with portions broken away of a corrugated post storage capacitor during fabrication, after removal of the alternating layers of doped and undoped material and after application of a layer of rugged polysilicon;

FIGURE 8 is a drawing in section with portions broken away showing the corrugated storage capacitor after applying a dielectric layer and a polysilicon layer; and

FIGURE 9 is a drawing in section with portion broken away showing the corrugated storage capacitor after applying a layer of rugged polysilicon, a dielectric layer, and a polysilicon layer.

DETAILED DESCRIPTION OF THE INVENTION

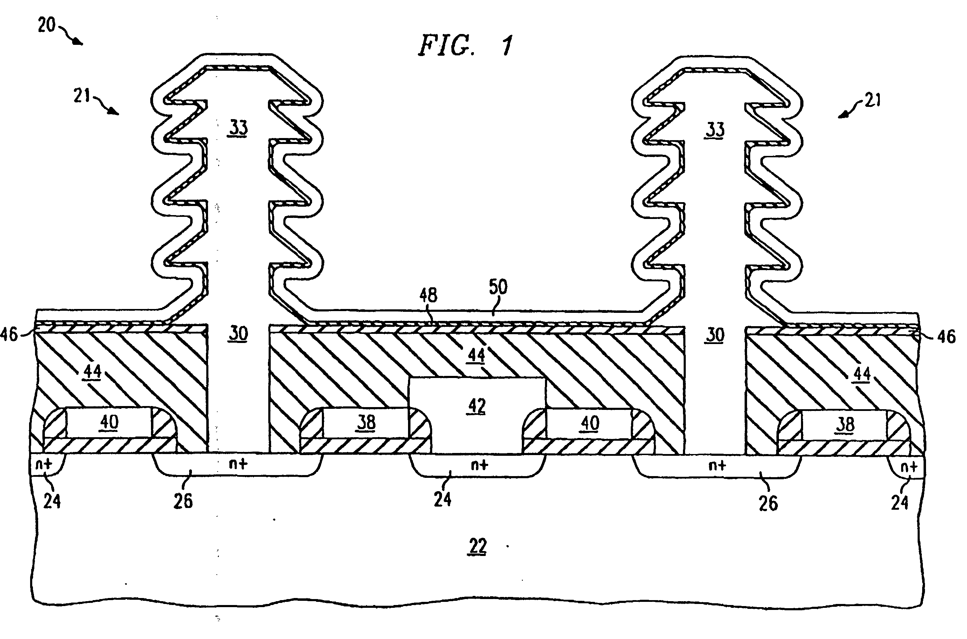

The preferred embodiments of the present invention and its advantages are best understood by referring to FIGURES 1-9 of the drawings, like numerals being used for like and corresponding parts of the various drawings.

FIGURE 1 shows two dynamic random access memory (DRAM) cells 20 disposed on semiconductor substrate 22 constructed according to the teachings of the present invention. Semiconductor substrate 22 is typically a p-type substrate, although it should be understood that other substrates may be used. Memory cells 20 are preferably dynamic random access memory cells. However, the present invention may be used to form a wide variety of memory cells and other electronic devices that require a relatively large amount of capacitance in a relatively small total volume. Doped source regions 24 and doped drain regions 26 are shown in FIGURE 1. With a p-type substrate, source regions 24 and drain regions 26 are typically doped with n-type impurities.

A corrugated post storage capacitor 21 extends from drain region 26 and includes corrugated post storage electrode 30, dielectric 48, and a second electrode 50.

The corrugated post storage electrode 30 may be patterned to form separate corrugated post storage electrodes for multiple memory cells. The storage electrode 30, may be formed of doped silicon, which may be doped polysilicon, and conductively coupled to the drain region 26 as shown in FIGURE 1. Corrugated post storage electrode 30 includes a corrugated portion 33. The corrugated portion 33 allows for enhanced surface area contact between the corrugated post storage electrode 30 and the dielectric 48, thereby increasing the memory capacity of the storage electrode 30 and therefore the capacity of storage capacitor 21. Dielectric material 48 is formed on the exterior of corrugated post storage electrode 30, and may extend to the corrugated post storage electrode in an adjacent memory cell. Corrugated post storage electrode 30 may be made of doped polysilicon and may have a doping level somewhere in the region of 1-5 x $10^{20}$ atoms/cm$^3$ of phosphorous. However, other doping levels and dopants may be used without departing from the teachings of the present invention. Second electrode 50 is formed on the exterior of dielectric material 48 and may extend to the storage capacitor in an adjacent memory cell.

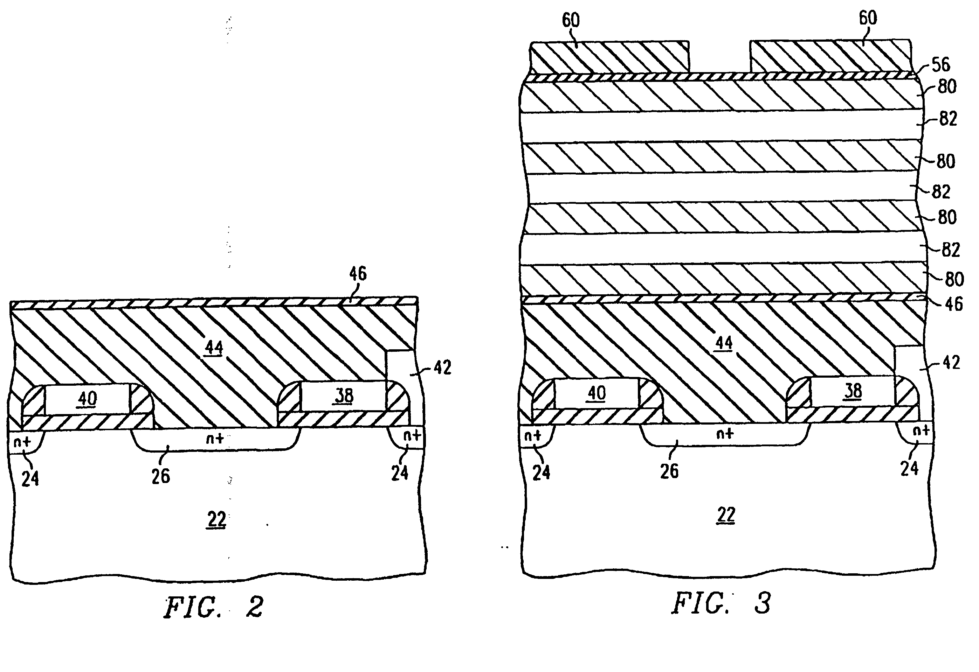

The memory cell 20 also includes an insulating layer 44, such as an oxide, and a masking layer 46, such as a nitride. Insulating layer 44 and masking layer 46 facilitate formation of storage capacitor 21 as described in more detail in connection with FIGURES 2-9.

One method of fabrication of the memory cell 20, including corrugated post storage capacitor 21, is described below in conjunction with FIGURES 2-9. FIGURE 2 illustrates a step in a method of fabrication of the corrugated post storage capacitor 21 shown in FIGURE 1 according to the teachings of the present invention. After formation of sources 24, drains 26, gates 38 and 40, and bitline 42, which may be constructed according to teachings well known in the art, an insulating layer 44, such as oxide, is placed over these elements. In addition, a masking layer 46, such as nitride, is placed over insulating layer 44. An enlarged view of the masking layer 46 and insulating layer 44 overlying drain region 26 is shown in FIGURE 2.

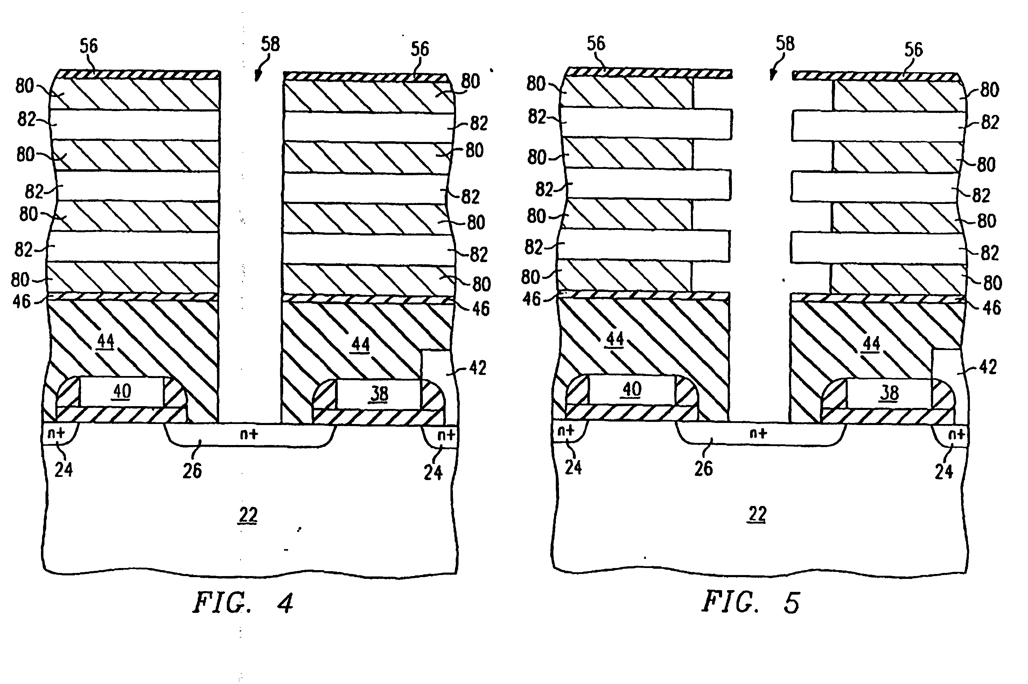

As illustrated in FIGURE 3, alternating layers 80 and 82 of first material 80 and second material 82 material are deposited, as shown in FIGURE 3. Overlying the alternating layers 80, 82 is a masking layer 56, such as nitride. The first and second materials have different selectivities in an etch process and preferably have vastly different selectivities. Etch selectivities in the ratio of 20:1 may be used. For example, the first material layers 80 could comprise TEOS (tetra ethoxysilane) and the second material layers 82 could comprise an SACVD (subatmospheric chemical-vapor deposition) oxide or PSG (phosphosilicate glass). Various combinations of first and second materials will be apparent to those skilled in the art. For example, combinations of doped and undoped oxides or hard and soft oxides could be used. The first material 80 and second material 82 are capable of being etched selectively with respect to polysilicon. An etch selectivity ratio on the order of 20 to 1 or greater is desirable.

The thickness of alternating layers 80 and 82 may be of the order of 200 to 500 Angstroms. Although shown as having the same thickness, it should be noted that layers 80 and 82 need not be of the same thickness. The thickness is a design variable chosen on the basis of, for example, desired surface area and the area required for the subsequent steps of forming the capacitor dielectric 48 in the second node 50 of the storage capacitor 21. The number of alternating layers 80, 82 may also vary depending on the surface area desired and the mechanical stability/reliability of the resulting structure.

As shown in FIGURES 3 and 4, through techniques well known in the art, such as using a mask 60, a pattern is formed in masking layer 56 and a void region is created in the alternating layers 80, 82 through an anisotropic etch. The same pattern is formed in mask layer 46 and a void region 58 is extended through insulating layer 44 to the drain region 26.

As shown in FIGURE 5, after the creation of void region 58, a selective etch is performed to etch the first material layers 80 selectively with respect to the second material layers 82. The first material layers 80 are etched radially to undercut the first material layers 80 from the second material layers 82, as shown in FIGURE 5. Although shown with first material layers 80 undercutting the second material layers 82, it will be apparent to those skilled in the art that the etch selectivities could be selected such that second material layer 82 undercuts first material layer 80 without departing from the teachings of the present invention.

Additionally, although the alternating layers are shown to include one more layer of first material 80 then second material 82, the alternating layers could include an equal number of layers of the first and second materials. The etch may be either a wet etch or a dry etch, and the etch chemistry and type may vary depending on the composition of the first and second materials. For example, if TEOS and 11% PSG are used, respectively, a vapor HF etch with less than 1/% unbuffered HF may be used for a duration of the order of 35 to 40 seconds. The duration of the etch is determined by the extent of the undercut desired. Other appropriate etches, such as an appropriate plasma etch, will be apparent to those of ordinary skill in the art having reference to the specification.

After the selective etching of the alternating layers, the corrugated post storage electrode 30 is formed through selective silicon deposition of doped silicon, which may be doped polysilicon, in void region 58. Selective silicon deposition allows the growth of silicon only upon silicon and not upon the oxide or nitride layers and is well known in the art. The chemical reactions associated with the use of dichlorosilane for selective silicon deposition is given below.

$$SiH_2Cl_2(g) \Leftrightarrow_- SiH_2Cl_2^*$$

$$SiH_2Cl_2^* \rightarrow SiCl_2^* + H2\ (g)$$

$$SiCl_2^* + H_2 \Leftrightarrow Si(s) + 2HCl\ (g)$$

\* = absorbed

For these particular chemical reactions, additional HCl may be added to eliminate nuclei on the dielectric or masking layer surfaces.

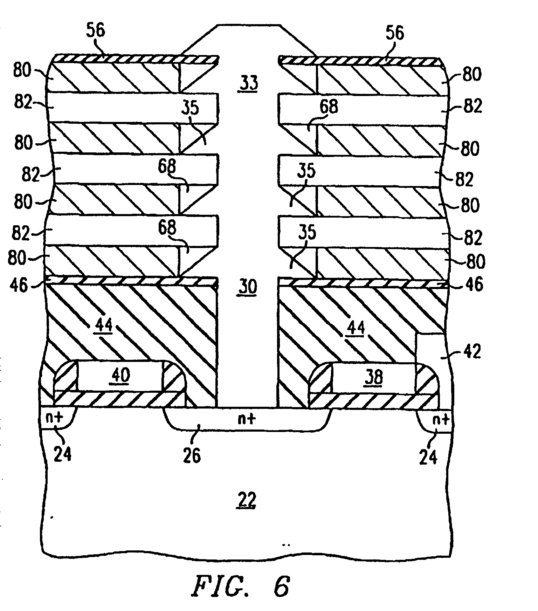

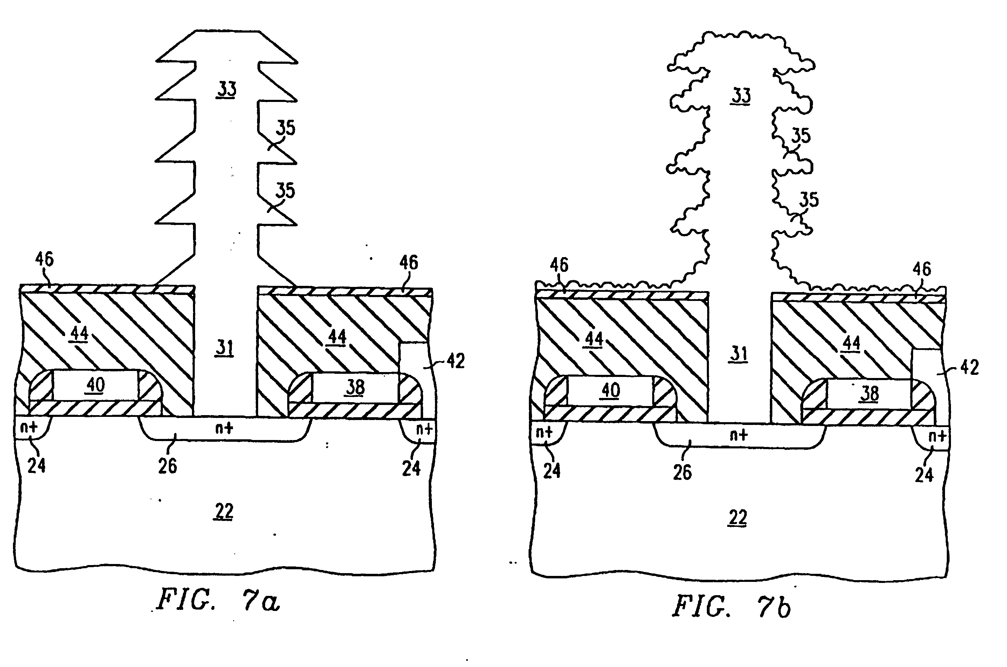

Doped polysilicon may be deposited in void region 58 through selective silicon deposition. Additionally, by overgrowing the silicon over each first layer 80 into the undercut areas, a capped portion 35 of storage electrode 30 is formed as shown in FIGURES 6 and 7. Overgrowing the silicon on top of the alternating layers and into the undercut areas creates a corrugated post section 33, which provides an increased surface area for storage electrode 30. Areas 68 are void regions where silicon does not form. The doped polysilicon is preferably doped with a doping level somewhere in the region of 1-5 x $10^{20}$ atoms/cm$^3$ of phosphorous, although other doping levels and dopants may be employed. The increased contact area between the corrugated post storage electrode 30 and the dielectric 48 provides increased storage capacity of storage capacitor 52, thereby increasing the memory capacity of each memory cell 20. Therefore, larger memory capacity DRAMS may be constructed without increasing their physical size.

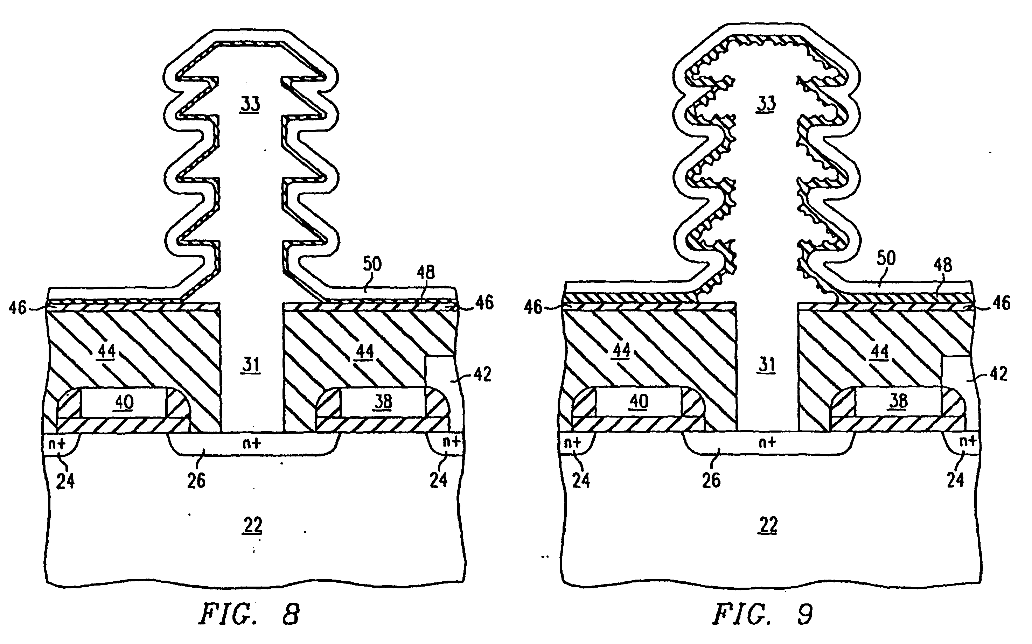

After formation of corrugated post storage electrode 30, the masking layer 56 and alternating layers of first and second materials 80 and 82 are etched, leaving the corrugated post storage electrode shown in FIGURE 7. At this point, a thin layer of rugged polysilicon may be deposited and anisotropically etched to leave a textured surface on the corrugated post storage electrode 30 and over the insulating layer 46 (FIGURE 7b). The rugged polysilicon may then be anisotropically etched to leave the textured surface on the corrugated post storage electrode, as shown in FIGURE 9. The rugged polysilicon allows for further surface area enhancement.

Methods for depositing rugged polysilicon to further enhance the surface area are well known in the art. At certain temperatures and pressures, deposition of polysilicon forms nodules on the surface and as arriving silicon atoms reach the surface, they migrate across the surface to form one of the nodules forming what is called rugged polysilicon or hemispherical grain polysilicon. This is in contrast to a smooth continuous film which is provided with standard polysilicon. Rugged polysilicon is known to produce a surface area of approximately 2.2 times that of smooth silicon.

The corrugated post storage capacitor 21 is completed by forming a capacitor dielectric over the corrugated post storage electrode 30, and by formation of a layer 50 of silicon to form the second electrode of the corrugated post storage capacitor 21. The second node 50 of the corrugated post storage capacitor 21 preferably comprises doped polysilicon. The completed corrugated post storage capacitor is shown in FIGURE 8. A coupled corrugated post storage capacitor with a layer of rugged polysilicon is shown in FIGURE 9.

## Claims

1.  A method for forming a storage capacitor (21) for a dynamic random access memory cell (20) having a storage capacitor comprising the steps of:

    depositing a first film (80) having a first etch selectivity;
    depositing a second film (82) over the first film (80) having a different second etch selectivity;
    repeating the steps of depositing the first film (80) and depositing the second film (82) to form a plurality of first film layers (80) alternated with a plurality of second film layers (82);
    etching a void (58) through the plurality of first film layers (80) and second film layers (82);
    selectively etching the plurality of first film layers (80) with respect to second film layers (82) to form a plurality of undercut regions;
    selectively depositing silicon only upon the silicon in the void and not upon the first and second films;
    overgrowing the selectively deposited silicon to fill at least a portion of the undercut areas;
    removing the plurality of first film layers (80) and second film layers (82);
    forming a capacitor dielectric (48) over the selectively deposited silicon, and
    depositing a conductive material (50) over the dielectric (48).

2.  The method of claim 1 further comprising the steps of depositing an insulating layer (44) and a masking layer (46) over the substrate (22) prior to deposition of the first film (80) and etching a void (58) in the masking layer (46) and insulating layer (44).

3.  The method of claim 1 or claim 2, wherein the step of selectively depositing silicon comprises depositing a doped polysilicon in the range of $1 \times 10^{20}$ atoms per $cm^3$ to $5 \times 10^{20}$ atoms/$cm^3$ of phosphorous.

4.  The method of any preceding claim, wherein the step of depositing the first film (80) comprises depositing a material comprising tetraethoxysilane.

5.  The method of any preceding claim, wherein the step of depositing the second film (82) comprises despositing a material comprising phosphosilicate glass.

6.  The method of any preceding claim, wherein the step of depositing the second film (82) comprises depositing a material comprising SACVD oxide.

7.  The method of any preceding claim further comprising the step of depositing a layer of rugged polysilicon over the selectively deposited silicon prior to forming the dielectric (48) and depositing the conductive material (50) over the dielectric.

8.  The method of any preceding claim wherein the first etch selectivity and the second etch selectivity differ by a ratio of at least 20:1.

## Patentansprüche

1.  Verfahren zum Bilden eines Speicherkondensators (21) für eine einen Speicherkondensator besitzende Zelle (20) eines dynamischen Direktzugriffsspeichers, mit den folgenden Schritten:

    Ablagern einer ersten Schicht (80) mit einer ersten Ätzselektivität;

    Ablagern einer zweiten Schicht (82) mit einer zweiten, verschiedenen Ätzselektivität auf der ersten Schicht (80);

    Wiederholen der Schritte des Ablagerns der ersten Schicht (80) und des Ablagerns der zweiten Schicht (82), um mehrere erste Schichtlagen (80), die mit mehreren zweiten Schichtlagen (82) abwechseln, zu bilden;

    Ätzen eines Hohlraums (58) durch die mehreren ersten Schichtlagen (80) und zweiten Schichtlagen (82);

    wahlweises Ätzen der mehreren ersten Schichtlagen (80) in Bezug auf die zweiten Schichtlagen (82), um mehrere unterschnittene Bereiche zu bilden;

wahlweises Ablagern von Silicium nur auf dem Silicium in dem Hohlraum und nicht auf der ersten und auf der zweiten Schicht;

Aufwachsenlassen des wahlweise abgelagerten Siliciums, um wenigstens einen Teil der unterschnittenen Bereiche zu füllen;

Entfernen der mehreren ersten Schichtlagen (80) und zweiten Schichtlagen (82);

Bilden eines Kondensatordielektrikums (48) auf dem wahlweise abgelagerten Silicium und

Ablagern eines leitenden Werkstoffs (50) auf dem Dielektrikum (48).

2. Verfahren nach Anspruch 1, das ferner die Schritte des Ablagerns einer isolierenden Lage (44) und einer maskierenden Lage (46) auf dem Substrat (22) vor dem Ablagern der ersten Schicht (80) und des Ätzens eines Hohlraums (58) in der maskierenden Lage (46) und der isolierenden Lage (44) umfasst.

3. Verfahren nach Anspruch 1 oder Anspruch 2, bei dem der Schritt des wahlweisen Ablagerns von Silicium das Ablagern von dotiertem Polysilicium im Bereich von $1 \cdot 10^{20}$ Atome pro $cm^3$ bis $5 \cdot 10^{20}$ Atome/$cm^3$ Phosphor umfasst.

4. Verfahren nach einem vorhergehenden Anspruch, bei dem der Schritt des Ablagerns der ersten Schicht (80) das Ablagern eines Werkstoffs, der Tetraethoxisilan enthält, umfasst.

5. Verfahren nach einem vorhergehenden Anspruch, bei dem der Schritt des Ablagerns der zweiten Schicht (82) das Ablagern eines Werkstoffs, der Phosphorsilikatglas enthält, umfasst.

6. Verfahren nach einem vorhergehenden Anspruch, bei dem der Schritt des Ablagerns der zweiten Schicht (82) das Ablagern eines Werkstoffs, der SACVD-Oxid enthält, umfasst.

7. Verfahren nach einem vorhergehenden Anspruch, das ferner den Schritt des Ablagerns einer Lage aus zerklüftetem Polysilicium auf dem wahlweise abgelagerten Silicium vor dem Bilden des Dielektrikums (48) und dem Ablagern des leitenden Materials (50) auf dem Dielektrikum umfasst.

8. Verfahren nach einem vorhergehenden Anspruch, bei dem sich die erste Ätzselektivität und die zweite Ätzselektivität in einem Verhältnis von wenigstens 20:1 unterscheiden.

## Revendications

1. Procédé pour former un condensateur de stockage (21) pour une cellule de mémoire dynamique à accès direct (20) comportant un condensateur de stockage, comprenant les étapes consistant à:

déposer un premier film (80) possédant une première sélectivité vis-à-vis de l'attaque chimique;

déposer sur le premier film (80) un second film (82) possédant une seconde sélectivité vis-à-vis de l'attaque chimique;

répéter les étapes de dépôt du premier film (80) et de dépôt du second film (82) de manière à former une pluralité de couches du premier film (80) alternant avec une pluralité de couches du second film (82);

former par attaque chimique un évidement (58) à travers la pluralité de couches du premier film (80) et de couches du second film (82);

réaliser l'attaque chimique sélective de la pluralité de couches du premier film (80) et de la pluralité de couches du second film (82) pour former une pluralité de régions découpées en dépouille;

déposer sélectivement du silicium sur le silicium situé dans l'évidement et non pas sur les premier et second films;

faire croître de façon excessive le silicium déposé sélectivement pour remplir au moins une partie des zones en dépouille;

éliminer la pluralité de couches du premier film (80) et de couches du second film (82);

former un diélectrique (48) du condensateur au-dessus du silicium déposé sélectivement; et

déposer un matériau conducteur (50) sur le diélectrique (48).

2. Procédé selon la revendication 1, comprenant en outre les étapes consistant à déposer une couche isolante (44) et une couche de masquage (46) sur le substrat (22) avant le dépôt du premier film (80), et former par attaque chimique un évidement (58) dans la couche de masquage (46) et dans la couche isolante (44).

3. Procédé selon la revendication 1 ou la revendication 2, selon lequel l'étape de dépôt sélectif de silicium comprend le dépôt de polysilicium dopé dans la gamme de $1 \times 10^{20}$ atomes par cm$^3$ à $5 \times 10^{20}$ atomes/cm$^3$ de phosphore.

4.  Procédé selon l'une quelconque des revendications précédentes, selon lequel l'étape de dépôt du premier film (80) comprend le dépôt d'un matériau comprenant du tétraéthoxysilane.

5.  Procédé selon l'une quelconque des revendications précédentes, selon lequel l'étape de dépôt du second film (82) comprend le dépôt d'un matériau comprenant du verre aux phosphosilicates.

6.  Procédé selon l'une quelconque des revendications précédentes, selon lequel l'étape de dépôt du second film (82) comprend le dépôt d'un matériau comprenant un oxyde SACVD.

7.  Procédé selon l'une quelconque des revendications précédentes, comprenant en outre l'étape consistant à déposer une couche polysilicium rugueux sur le polysilicium déposé sélectivement avant la formation du diélectrique (48) et déposer le matériau conducteur (50) sur le diélectrique.

8.  Procédé selon l'une quelconque des revendications précédentes, selon lequel la première sélectivité vis-à-vis de l'attaque chimique et la seconde sélectivité vis-à-vis de l'attaque chimique diffèrent d'un rapport égal au moins à 20:1.

FIG. 1

FIG. 3

FIG. 2

EP 0 810 653 B1

FIG. 4

FIG. 5

FIG. 6

EP 0 810 653 B1

FIG. 7b

FIG. 7a

FIG. 8

FIG. 9

EP 0 810 653 B1